# EUROPEAN PATENT APPLICATION

(11) **EP 1 640 950 A2**
(43) Date of publication of application: **29.03.2006**
(21) Application number: 05255639.6
(22) Date of filing: 14.09.2005
(51) Int. Cl.: G09G 3/34, G02B 26/00, G02B 26/02

(54) **MEMS display device and data writing method adapted therefor**

(30) Priority: 27.09.2004 US 613483 P; 06.04.2005 US 100762
(71) Applicant: IDC, LLC, San Francisco, CA 94107 (US)
(72) Inventor: Chui, Clarence, San Mateo, CA 94402 (US); Kothari, Manish, Cupertino, CA 95014 (US)
(74) Representative: Dunlop, Hugh Christopher

(57) **Abstract**

Charge balanced display data writing methods use write and hold cycles of opposite polarity during selected frame update periods. A release cycle may be provided to reduce the chance that a given display element wil become stuck in an actuated state.

## Description

### Background

Microelectromechanical systems (MEMS) include micro mechanical elements, actuators, and electronics. Micromechanical elements may be created using deposition, etching, and or other micromachining processes that etch away parts of substrates and/or deposited material layers or that add layers to form electrical and electromechanical devices. One type of MEMS device is called an interferometric modulator. An interferometric modulator may comprise a pair of conductive plates, one or both of which may be transparent and/or reflective in whole or part and capable of relative motion upon application of an appropriate electrical signal. One plate may comprise a stationary layer deposited on a substrate, the other plate may comprise a metallic membrane separated from the stationary layer by an air gap. Such devices have a wide range of applications, and it would be beneficial in the art to utilize and/or modify the characteristics of these types of devices so that their features can be exploited in improving existing products and creating new products that have not yet been developed.

### Summary

The system, method, and devices of the invention each have several aspects, no single one of which is solely responsible for its desirable attributes. Without limiting the scope of this invention, its more prominent features will now be discussed briefly. After considering this discussion, and particularly after reading the section entitled "Detailed Description of Certain Embodiments" one will understand how the features of this invention provide advantages over other display devices.

In one embodiment, a method of actuating a MEMS display element is provided, wherein the MEMS display element comprises a portion of an array of MEMS display elements. The method includes writing display data to the MEMS display element with a potential difference of a first polarity during a first portion of a display write process, and re-writing the display data to the MEMS display element with a potential difference having a polarity opposite the first polarity during a second portion of the display write process. Subsequently, a first bias potential having the first polarity is applied to the MEMS display element during a third portion of the display write process and a second bias potential having the opposite polarity is applied to the MEMS display element during a fourth portion of the display write process.

In another embodiment, a method of maintaining a frame of display data on an array of MEMS display elements includes alternately applying approximately equal bias voltages of opposite polarities to the MEMS display elements for periods of time defined at least in part by the inverse of a rate at which frames of display data are received by a display system. Each period of time may be substantially equal to 1/(2f) or 1/(4f), wherein f is a defined frequency of frame refresh cycles.

In another embodiment, a method of driving a microelectromechanical systems (MEMS) display includes periodically releasing substantially all pixels of said display, wherein said periodic releasing occurs for each pixel at an infrequent rate such that there is no perceptible affect on visual appearance of the display to a normal observer.

In another embodiment, a method of writing frames of display data to an array of MEMS display elements at a rate of one frame per defined frame update period includes writing display data to the MEMS display elements, wherein the writing takes less than the frame update period and applying a series of bias potentials of alternating polarity to the MEMS display elements for the remainder of the frame update period.

Display devices are also provided. In one such embodiment, a MEMS display device is configured to display images at a frame update rate, the frame update rate defining a frame update period. The display device includes row and column driver circuitry configured to apply a polarity balanced sequence of bias voltages to substantially all columns of a MEMS display array for portions of at least one frame update period, wherein the portions are defined by a time remaining between completing a frame write process for a first frame, and beginning a frame write process for a next subsequent frame.

In another embodiment, a MEMS display device comprises means for displaying an image having a plurality of pixels. The device further comprises means for periodically releasing substantially all pixels of said displaying means, wherein said periodic releasing occurs for each pixel at an infrequent rate such that there is no perceptible affect on visual appearance of the displaying means to a normal observer.

In another embodiment, a MEMS display device is configured to display images at a frame update rate, the frame update rate defining a frame update period. The device comprises means for displaying an image. The device further comprises means for applying a polarity balanced sequence of bias voltages to said displaying means for portions of at least one frame update period, wherein said portions are defined by a time remaining between completing a frame write process for a first frame, and beginning a frame write process for a next subsequent frame.

### Brief Description of the Drawings

Figure 1 is an isometric view depicting a portion of one embodiment of an interferometric modulator display in which a movable reflective layer of a first interferometric modulator is in a released position and a movable reflective layer of a second interferometric modulator is in an actuated position.
Figure 2 is a system block diagram illustrating one embodiment of an electronic device incorporating a 3x3 interferometric modulator display.
Figure 3 is a diagram of movable mirror position versus applied voltage for one exemplary embodiment of an interferometric modulator of Figure 1.
Figure 4 is an illustration of a set of row and column voltages that may be used to drive an interferometric modulator display.
Figures 5A and 5B illustrate one exemplary timing diagram for row and column signals that may be used to write a frame of display data to the 3x3 interferometric modulator display of Figure 2.
Figure 6A is a cross section of the device of Figure 1.
Figure 6B is a cross section of an alternative embodiment of an interferometric modulator.
Figure 6C is a cross section of another alternative embodiment of an interferometric modulator.
Figure 7 is a timing diagram illustrating application of opposite write polarities to different frames of display data.
Figure 8 is a timing diagram illustrating write and hold cycles during a frame update period in a first embodiment of the invention.
Figure 9 is a timing diagram illustrating write and hold cycles during a frame update period in a first embodiment of the invention.
Figure 10 is a timing diagram illustrating variable length write and hold cycles during frame update periods.
Figures 11A and 11B are system block diagrams illustrating an embodiment of a visual display device comprising a plurality of interferometric modulators.

### Detailed Description of Preferred Embodiments

The following detailed description is directed to certain specific embodiments of the invention. However, the invention can be embodied in a multitude of different ways. In this description, reference is made to the drawings wherein like parts are designated with like numerals throughout. As will be apparent from the following description, the invention may be implemented in any device that is configured to display an image, whether in motion (e.g., video) or stationary (e.g., still image), and whether textual or pictorial. More particularly, it is contemplated that the invention may be implemented in or associated with a variety of electronic devices such as, but not limited to, mobile telephones, wireless devices, personal data assistants (PDAs), hand-held or portable computers, GPS receivers/navigators, cameras, MP3 players, camcorders, game consoles, wrist watches, clocks, calculators, television monitors, flat panel displays, computer monitors, auto displays (e.g., odometer display, etc.), cockpit controls and/or displays, display of camera views (e.g., display of a rear view camera in a vehicle), electronic photographs, electronic billboards or signs, projectors, architectural structures, packaging, and aesthetic structures (e.g., display of images on a piece of jewelry). MEMS devices of similar structure to those described herein can also be used in non-display applications such as in electronic switching devices.

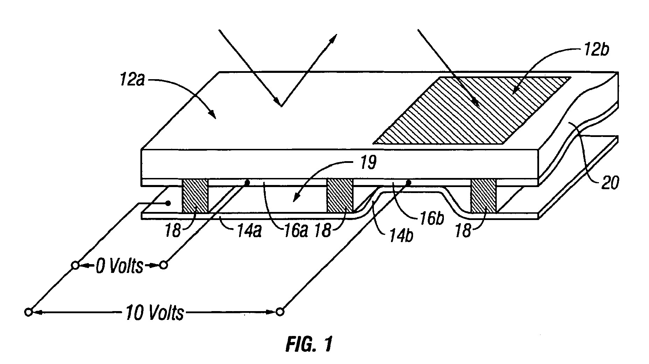

One interferometric modulator display embodiment comprising an interferometric MEMS display element is illustrated in Figure 1. In these devices, the pixels are in either a bright or dark state. In the bright ("on" or "open") state, the display element reflects a large portion of incident visible light to a user. When in the dark ("off" or "closed") state, the display element reflects little incident visible light to the user. Depending on the embodiment, the light reflectance properties of the "on" and "off" states may be reversed. MEMS pixels can be configured to reflect predominantly at selected colors, allowing for a color display in addition to black and white.

Figure 1 is an isometric view depicting two adjacent pixels in a series of pixels of a visual display, wherein each pixel comprises a MEMS interferometric modulator. In some embodiments, an interferometric modulator display comprises a row/column array of these interferometric modulators. Each interferometric modulator includes a pair of reflective layers positioned at a variable and controllable distance from each other to form a resonant optical cavity with at least one variable dimension. In one embodiment, one of the reflective layers may be moved between two positions. In the first position, referred to herein as the released state, the movable layer is positioned at a relatively large distance from a fixed partially reflective layer. In the second position, the movable layer is positioned more closely adjacent to the partially reflective layer. Incident light that reflects from the two layers interferes constructively or destructively depending on the position of the movable reflective layer, producing either an overall reflective or non-reflective state for each pixel.

The depicted portion of the pixel array in Figure 1 includes two adjacent interferometric modulators 12a and 12b. In the interferometric modulator 12a on the left, a movable and highly reflective layer 14a is illustrated in a released position at a predetermined distance from a fixed partially reflective layer 16a. In the interferometric modulator 12b on the right, the movable highly reflective layer 14b is illustrated in an actuated position adjacent to the fixed partially reflective layer 16b.

The fixed layers 16a, 16b are electrically conductive, partially transparent and partially reflective, and may be fabricated, for example, by depositing one or more layers each of chromium and indium-tin-oxide onto a transparent substrate 20. The layers are patterned into parallel strips, and may form row electrodes in a display device as described further below. The movable layers 14a, 14b may be formed as a series of parallel strips of a deposited metal layer or layers (orthogonal to the row electrodes 16a, 16b) deposited on top of posts 18 and an intervening sacrificial material deposited between the posts 18. When the sacrificial material is etched away, the deformable metal layers are separated from the fixed metal layers by a defined air gap 19. A highly conductive and reflective material such as aluminum may be used for the deformable layers, and these strips may form column electrodes in a display device.

With no applied voltage, the cavity 19 remains between the layers 14a, 16a and the deformable layer is in a mechanically relaxed state as illustrated by the pixel 12a in Figure 1. However, when a potential difference is applied to a selected row and column, the capacitor formed at the intersection of the row and column electrodes at the corresponding pixel becomes charged, and electrostatic forces pull the electrodes together. If the voltage is high enough, the movable layer is deformed and is forced against the fixed layer (a dielectric material which is not illustrated in this Figure may be deposited on the fixed layer to prevent shorting and control the separation distance) as illustrated by the pixel 12b on the right in Figure 1. The behavior is the same regardless of the polarity of the applied potential difference. In this way, row/column actuation that can control the reflective vs. non-reflective pixel states is analogous in many ways to that used in conventional LCD and other display technologies.

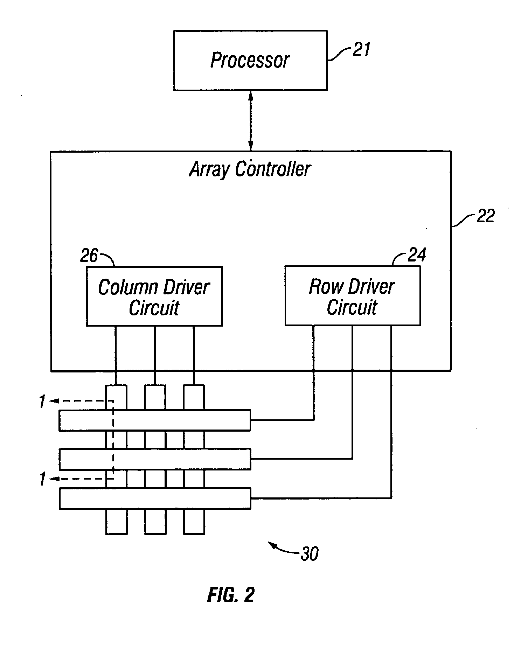

Figures 2 through 5 illustrate one exemplary process and system for using an array of interferometric modulators in a display application. Figure 2 is a system block diagram illustrating one embodiment of an electronic device that may incorporate aspects of the invention. In the exemplary embodiment, the electronic device includes a processor 21 which may be any general purpose single- or multi-chip microprocessor such as an ARM, Pentium®, Pentium II®, Pentium III® , Pentium IV® , Pentium® Pro, an 8051, a MIPS® , a Power PC® , an ALPHA® , or any special purpose microprocessor such as a digital signal processor, microcontroller, or a programmable gate array. As is conventional in the art, the processor 21 may be configured to execute one or more software modules. In addition to executing an operating system, the processor may be configured to execute one or more software applications, including a web browser, a telephone application, an email program, or any other software application.

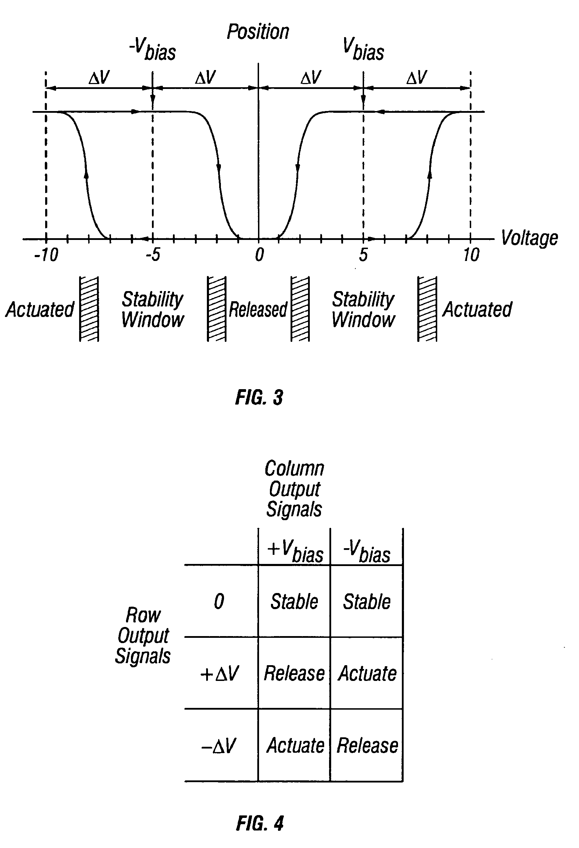

In one embodiment, the processor 21 is also configured to communicate with an array controller 22. In one embodiment, the array controller 22 includes a row driver circuit 24 and a column driver circuit 26 that provide signals to a pixel array 30. The cross section of the array illustrated in Figure 1 is shown by the lines 1-1 in Figure 2. For MEMS interferometric modulators, the row/column actuation protocol may take advantage of a hysteresis property of these devices illustrated in Figure 3. It may require, for example, a 10 volt potential difference to cause a movable layer to deform from the released state to the actuated state. However, when the voltage is reduced from that value, the movable layer maintains its state as the voltage drops back below 10 volts. In the exemplary embodiment of Figure 3, the movable layer does not release completely until the voltage drops below 2 volts. There is thus a range of voltage, about 3 to 7 V in the example illustrated in Figure 3, where there exists a window of applied voltage within which the device is stable in either the released or actuated state. This is referred to herein as the "hysteresis window" or "stability window." For a display array having the hysteresis characteristics of Figure 3, the row/column actuation protocol can be designed such that during row strobing, pixels in the strobed row that are to be actuated are exposed to a voltage difference of about 10 volts, and pixels that are to be released are exposed to a voltage difference of close to zero volts. After the strobe, the pixels are exposed to a steady state voltage difference of about 5 volts such that they remain in whatever state the row strobe put them in. After being written, each pixel sees a potential difference within the "stability window" of 3-7 volts in this example. This feature makes the pixel design illustrated in Figure 1 stable under the same applied voltage conditions in either an actuated or released pre-existing state. Since each pixel of the interferometric modulator, whether in the actuated or released state, is essentially a capacitor formed by the fixed and moving reflective layers, this stable state can be held at a voltage within the hysteresis window with almost no power dissipation. Essentially no current flows into the pixel if the applied potential is fixed.

In typical applications, a display frame may be created by asserting the set of column electrodes in accordance with the desired set of actuated pixels in the first row. A row pulse is then applied to the row 1 electrode, actuating the pixels corresponding to the asserted column lines. The asserted set of column electrodes is then changed to correspond to the desired set of actuated pixels in the second row. A pulse is then applied to the row 2 electrode, actuating the appropriate pixels in row 2 in accordance with the asserted column electrodes. The row 1 pixels are unaffected by the row 2 pulse, and remain in the state they were set to during the row 1 pulse. This may be repeated for the entire series of rows in a sequential fashion to produce the frame. Generally, the frames are refreshed and/or updated with new display data by continually repeating this process at some desired number of frames per second. A wide variety of protocols for driving row and column electrodes of pixel arrays to produce display frames are also well known and may be used in conjunction with the present invention.

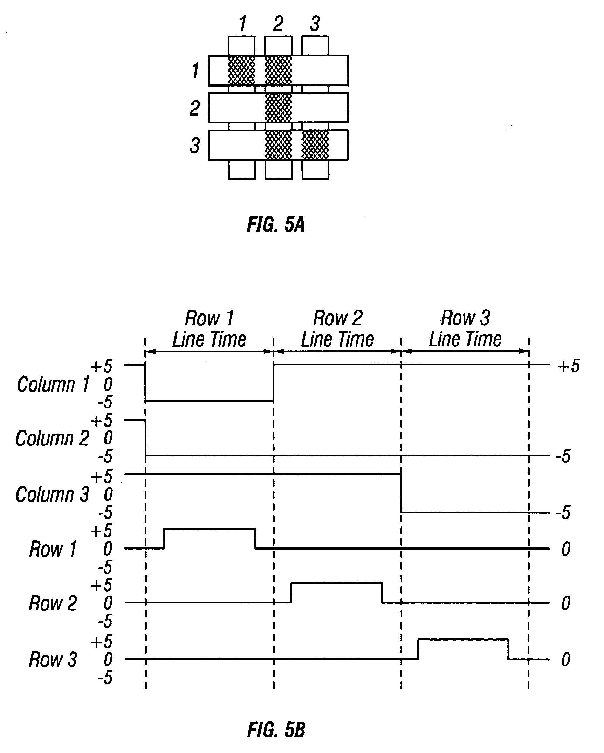

Figures 4 and 5 illustrate one possible actuation protocol for creating a display frame on the 3x3 array of Figure 2. Figure 4 illustrates a possible set of column and row voltage levels that may be used for pixels exhibiting the hysteresis curves of Figure 3. In the Figure 4 embodiment, actuating a pixel involves setting the appropriate column to -V_{bias}, and the appropriate row to +ΔV, which may correspond to -5 volts and +5 volts respectively Releasing the pixel is accomplished by setting the appropriate column to +V_{bias}, and the appropriate row to the same +ΔV, producing a zero volt potential difference across the pixel. In those rows where the row voltage is held at zero volts, the pixels are stable in whatever state they were originally in, regardless of whether the column is at +V_{bias}, or-V_{bias}. As is also illustrated in Figure 4, it will be appreciated that voltages of opposite polarity than those described above can be used, e.g., actuating a pixel can involve setting the appropriate column to +V_{bias}, and the appropriate row to-ΔV. In this embodiment, releasing the pixel is accomplished by setting the appropriate column to -V_{bias}, and the appropriate row to the same -ΔV, producing a zero volt potential difference across the pixel.

Figure 5B is a timing diagram showing a series of row and column signals applied to the 3x3 array of Figure 2 which will result in the display arrangement illustrated in Figure 5A, where actuated pixels are non-reflective. Prior to writing the frame illustrated in Figure 5A, the pixels can be in any state, and in this example, all the rows are at 0 volts, and all the columns are at +5 volts. With these applied voltages, all pixels are stable in their existing actuated or released states.

In the Figure 5A frame, pixels (1,1), (1,2), (2,2), (3,2) and (3,3) are actuated. To accomplish this, during a "line time" for row 1, columns 1 and 2 are set to-5 volts, and column 3 is set to +5 volts. This does not change the state of any pixels, because all the pixels remain in the 3-7 volt stability window. Row 1 is then strobed with a pulse that goes from 0, up to 5 volts, and back to zero. This actuates the (1,1) and (1,2) pixels and releases the (1,3) pixel. No other pixels in the array are affected. To set row 2 as desired, column 2 is set to -5 volts, and columns 1 and 3 are set to +5 volts. The same strobe applied to row 2 will then actuate pixel (2,2) and release pixels (2,1) and (2,3). Again, no other pixels of the array are affected. Row 3 is similarly set by setting columns 2 and 3 to -5 volts, and column 1 to +5 volts. The row 3 strobe sets the row 3 pixels as shown in Figure 5A. After writing the frame, the row potentials are zero, and the column potentials can remain at either +5 or -5 volts, and the display is then stable in the arrangement of Figure 5A. It will be appreciated that the same procedure can be employed for arrays of dozens or hundreds of rows and columns. It will also be appreciated that the timing, sequence, and levels of voltages used to perform row and column actuation can be varied widely within the general principles outlined above, and the above example is exemplary only, and any actuation voltage method can be used with the present invention.

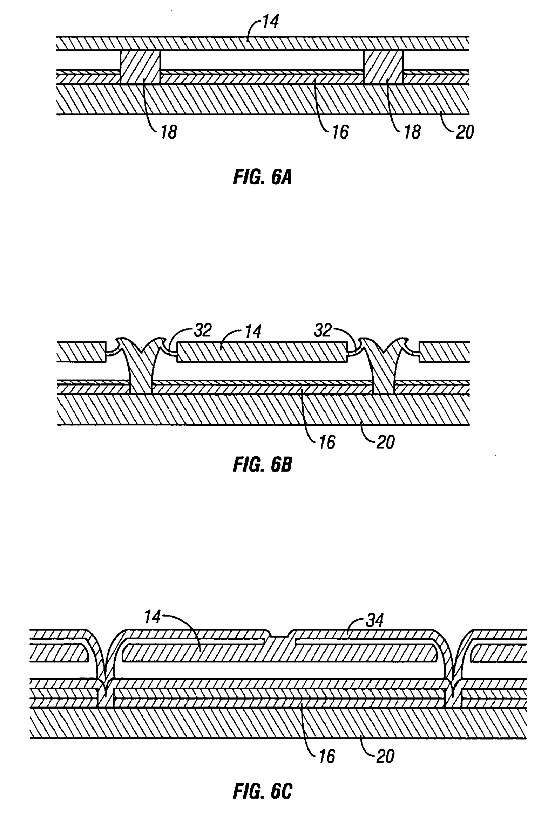

The details of the structure of interferometric modulators that operate in accordance with the principles set forth above may vary widely. For example, Figures 6A-6C illustrate three different embodiments of the moving mirror structure. Figure 6A is a cross section of the embodiment of Figure 1, where a strip of metal material 14 is deposited on orthogonally extending supports 18. In Figure 6B, the moveable reflective material 14 is attached to supports at the corners only, on tethers 32. In Figure 6C, the moveable reflective material 14 is suspended from a deformable layer 34. This embodiment has benefits because the structural design and materials used for the reflective material 14 can be optimized with respect to the optical properties, and the structural design and materials used for the deformable layer 34 can be optimized with respect to desired mechanical properties. The production of various types of interferometric devices is described in a variety of published documents, including, for example, U.S. Published Application 2004/0051929. A wide variety of well known techniques may be used to produce the above described structures involving a series of material deposition, patterning, and etching steps.

It is one aspect of the above described devices that charge can build on the dielectric between the layers of the device, especially when the devices are actuated and held in the actuated state by an electric field that is always in the same direction. For example, if the moving layer is always at a higher potential relative to the fixed layer when the device is actuated by potentials having a magnitude larger than the outer threshold of stability, a slowly increasing charge buildup on the dielectric between the layers can begin to shift the hysteresis curve for the device. This is undesirable as it causes display performance to change over time, and in different ways for different pixels that are actuated in different ways over time. As can be seen in the example of Figure 5B, a given pixel sees a 10 volt difference during actuation, and every time in this example, the row electrode is at a 10 V higher potential than the column electrode. During actuation, the electric field between the plates therefore always points in one direction, from the row electrode toward the column electrode.

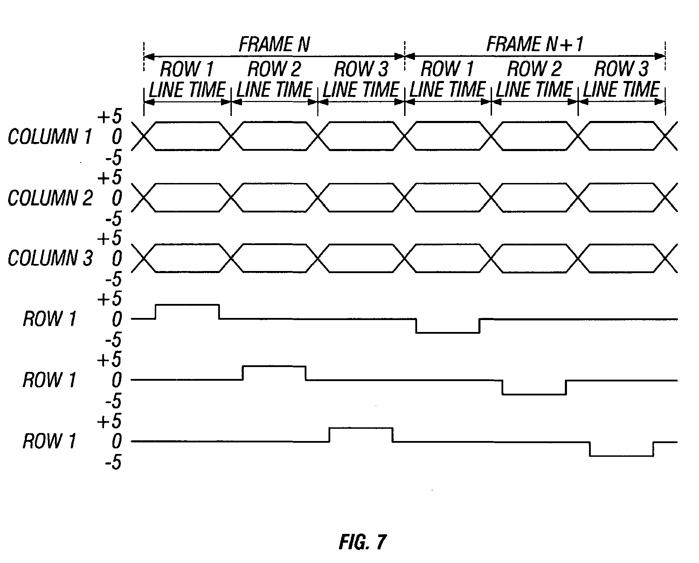

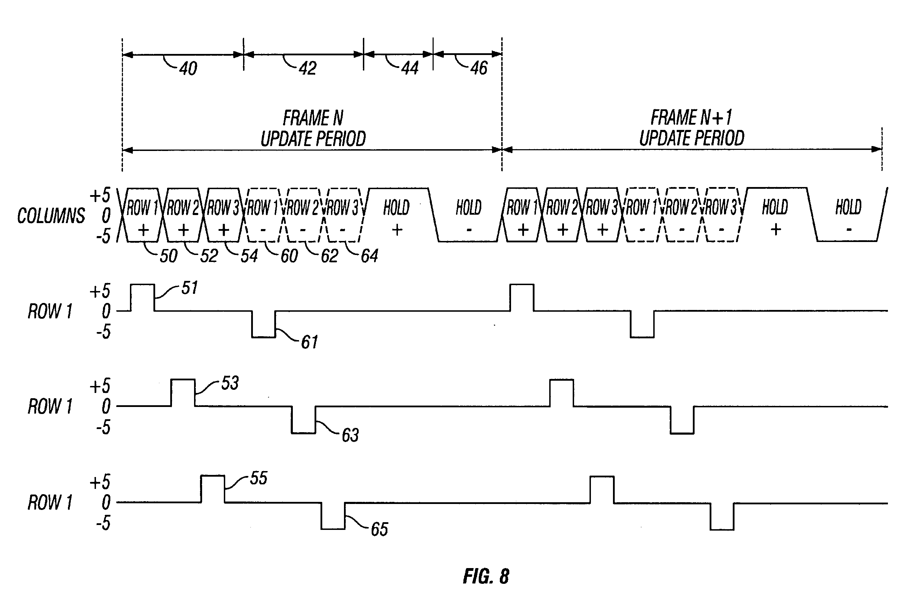

This problem can be reduced by actuating the MEMS display elements with a potential difference of a first polarity during a first portion of the display write process, and actuating the MEMS display elements with a potential difference having a polarity opposite the first polarity during a second portion of the display write process. This basic principle is illustrated in Figures 7, 8A, and 8B.

In Figure 7, two frames of display data are written in sequence, frame N and frame N+1. In this Figure, the data for the columns goes valid for row 1 (i.e., either +5 or-5 depending on the desired state of the pixels in row 1) during the row 1 line time, valid for row 2 during the row 2 line time, and valid for row 3 during the row 3 line time. Frame N is written as shown in Figure 5B, which will be termed positive polarity herein, with the row electrode 10 V above the column electrode during MEMS device actuation. During actuation, the column electrode may be at -5 V, and the scan voltage on the row is +5 V in this example. The actuation and release of display elements for Frame N is thus performed according to the center row of Figure 4 above.

Frame N+1 is written in accordance with the lowermost row of Figure 4. For Frame N+1, the scan voltage is -5 V, and the column voltage is set to +5 V to actuate, and -5 V to release. Thus, in Frame N+1, the column voltage is 10 V above the row voltage, termed a negative polarity herein. As the display is continually refreshed and/or updated, the polarity can be alternated between frames, with Frame N+2 being written in the same manner as Frame N, Frame N+3 written in the same manner as Frame N+1, and so on. In this way, actuation of pixels takes place in both polarities. In embodiments following this principle, potentialsof opposite polarities are respectively applied to a given MEMS element at defined times and for defined time durations that depend on the rate at which image data is written to MEMS elements of the array, and the opposite potential differences are each applied an approximately equal amount of time over a given period of display use. This helps reduce charge buildup on the dielectric over time.

A wide variety of modifications of this scheme can be implemented. For example, Frame N and Frame N+1 can comprise different display data. Alternatively, it can be the same display data written twice to the array with opposite polarities. One specific embodiment wherein the same data is written twice with opposite polarity signals is illustrated in additional detail in Figure 8.

In this Figure, Frame N and N+1 update periods are illustrated. These update periods are typically the inverse of a selected frame update rate that is defined by the rate at which new frames of display data are received by the display system. This rate may, for example, be 15 Hz, 30 Hz, or another frequency depending on the nature of the image data being displayed.

It is one feature of the display elements described herein that a frame of data can generally be written to the array of display elements in a time period shorter than the update period defined by the frame update rate. In the embodiment of Figure 8, the frame update period is divided into four portions or intervals, designated 40, 42, 44, and 46 in Figure 8. Figure 8 illustrates a timing diagram for a 3 row display, such as illustrated in Figure 5A.

During the first portion 40 of a frame update period, the frame is written with potential differences across the modulator elements of a first polarity. For example, the voltages applied to the rows and columns may follow the polarity illustrated by the center row of Figure 4 and Figure 5B. As with Figure 7, in Figure 8, the column voltages are not shown individually, but are indicated as a multi-conductor bus, where the column voltages are valid for row 1 data during period 50, are valid for row 2 data during period 52, and valid for row 3 data during period 54, wherein "valid" is a selected voltage which differs depending on the desired state of a display element in the column to be written. In the example of Figure 5B, each column may assume a potential of +5 or -5 depending on the desired display element state. As explained above, row pulse 51 sets the state of row 1 display elements as desired, row pulse 53 sets the state of row 2 display elements as desired, and row pulse 55 sets the state of row 3 display elements as desired.

During a second portion 42 of the frame update period, the same data is written to the array with the opposite polarities applied to the display elements. During this period, the voltages present on the columns are the opposite of what they were during the first portion 40. If the voltage was, for example, +5 volts on a column during time period 50, it will be-5 volts during time period 60, and vice versa. The same is true for sequential applications of sets of display data to the columns, e.g., the potential during period 62 is opposite to that of 52, and the potential during period 64 is opposite to that applied during time period 54. Row strobes 61, 63, 65 of opposite polarity to those provided during the first portion 40 of the frame update period rewrite the same data to the array during second portion 42 as was written during portion 40, but the polarity of the applied voltage across the display elements is reversed.

In the embodiment illustrated in Figure 8, both the first period 40 and the second period 42 are complete before the end of the frame update period. In this embodiment, this time period is filled with a pair of alternating hold periods 44 and 46. Using the array of Figures 3-5 as an example, during the first hold period 44, the rows are all held at 0 volts, and the columns are all brought to +5 V. During the second hold period 46, the rows remain at 0 volts, and the columns are all brought to -5 V. Thus, during the period following array writing of Frame N, but before array writing of Frame N+1, bias potentials of opposite polarity are each applied to the elements of the array. During these periods, the state of the array elements does not change, but potentials of opposite polarity are applied to minimize charge buildup in the display elements.

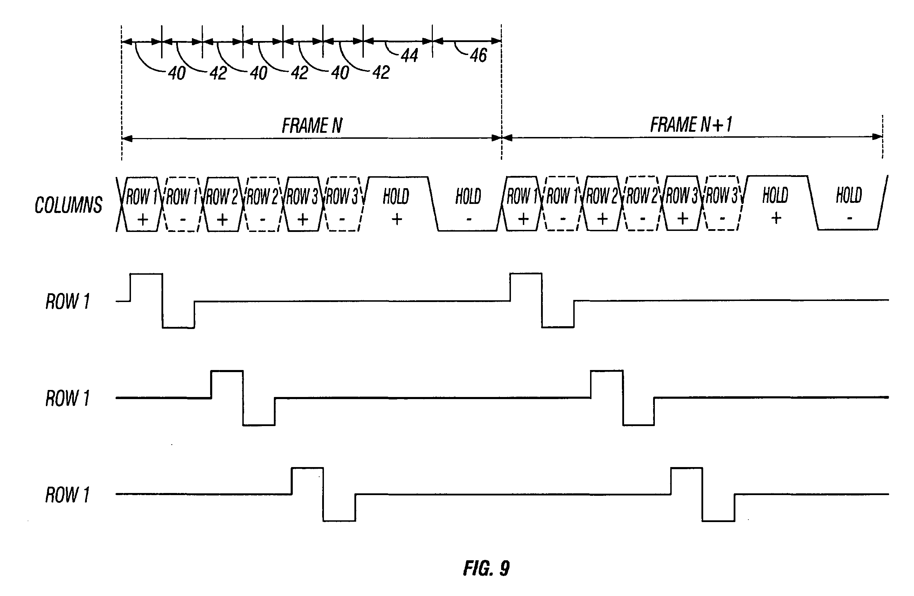

During the next frame update period for Frame N+1, the process may be repeated, as shown in Figure 8. It will be appreciated that a variety of modifications of this overall method may be utilized to advantageous effect. For example, more than two hold periods could be provided. Figure 9 illustrates an embodiment where the writing in opposite polarities is done on a row by row basis rather than a frame by frame basis. In this embodiment, the time periods 40 and 42 of Figure 8 are interleaved. In addition, the modulator may be more susceptible to charging in one polarity than the other, and so although essentially exactly equal positive and negative write and hold times are usually most advantageous, it might be beneficial in some cases to skew the relative time periods of positive and negative polarity actuation and holding slightly. Thus, in one embodiment, the time of the write cycles and hold cycles can be adjusted so as to allow the charge to balance out. In an exemplary embodiment, using values selected purely for illustration and ease of arithmetic, an electrode material can have a rate of charging in positive polarity is twice as fast the rate of charging in the negative polarity. If the positive write cycle, write+, is 10 ms, the negative write cycle, write-, could be 20 ms to compensate. Thus the write+ cycle will take a third of the total write cycle, and the write- cycle will take two-thirds of the total write time. Similarly the hold cycles could have a similar time ratio. In other embodiments, the change in electric field could be non-linear, such that the rate of charge or discharge could vary over time. In this case, the cycle times could be adjusted based on the non-linear charge and discharge rates.

In some embodiments, several timing variables are independently programmable to ensure DC electric neutrality and consistent hysteresis windows. These timing settings include, but are not limited to, the write+ and write- cycle times, the positive hold and negative hold cycle times, and the row strobe time.

While the frame update cycles discussed herein have a set order of write+, write-, hold +, and hold -, this order can be changed. In other embodiments, the order of cycles can be any other permutation of the cycles. In still other embodiments, different cycles and different permutations of cycles can be used for different display update periods. For example, Frame N might include only a write+ cycle, hold+ cycle, and a hold- cycle, while subsequent Frame N+1 could include only a write-, hold+, and hold- cycle. Another embodiment could use write+, hold+, write-, hold for one or a series of frames, and then use write-, hold-, write+, hold+ for the next subsequent one or series of frames. It will also be appreciated that the order of the positive and negative polarity hold cycles can be independently selected for each column. In this embodiment, some columns cycle through hold+ first, then hold-, while other columns go to hold- first and then to hold+. In one example, depending on the configuration of the column driver circuit, it may be more advantageous to set half the columns at -5 V and half at +5 V for the first hold cycle 44, and then switch all column polarities to set the first half to +5 V and the second half to-5 V for the second hold cycle 46.

It has also been found advantageous to periodically include a release cycle for the MEMS display elements. It is advantageous to perform this release cycle for one or more rows during some of the frame update cycles. This release cycle will typically be provided relatively infrequently, such as every 100,000 or 1,000,000 frame updates, or every hour or several hours of display operation. The purpose of this periodic releasing of all or substantially all pixels is to reduce the chance that a MEMS display element that is continually actuated for a long period due to the nature of the images being displayed will become stuck in an actuated state. In the embodiment of Figure 8, for example, period 50 could be a write+ cycle that writes all the display elements of row 1 into a released state every 100,000 frame updates. The same may be done for all the rows of the display with periods 52, 54, and/or 60, 62, 64. Since they occur infrequently and for short periods, these release cycles may be widely spread in time (e.g. every 100,000 or more frame updates or every hour or more of display operation) and spread at different times over different rows of the display so as to eliminate any perceptible affect on visual appearance of the display to a normal observer.

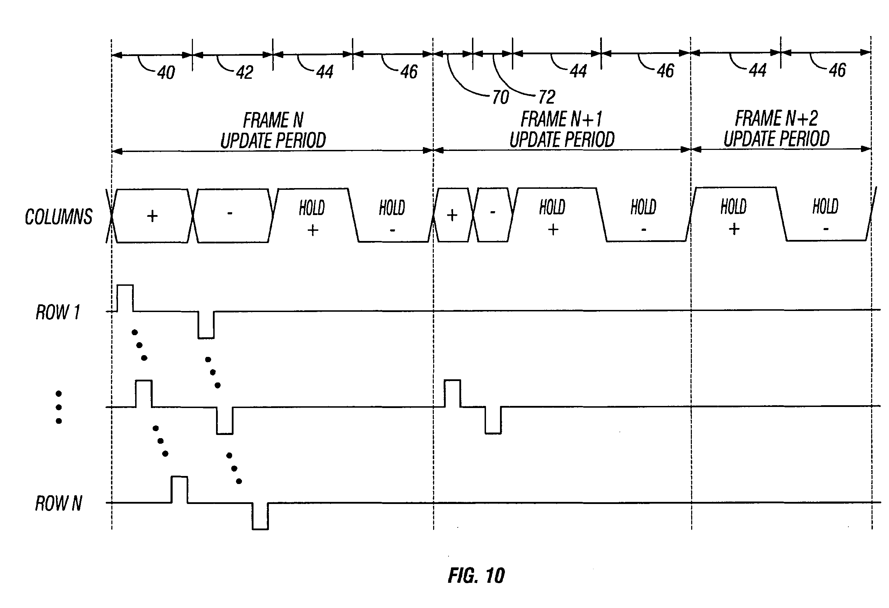

Figure 10 shows another embodiment wherein frame writing may take a variable amount of the frame update period, and the hold cycle periods are adjusted in length in order fill the time between completion of the display write process for one frame and the beginning of the display write process for the subsequent frame. In this embodiment, the time to write a frame of data, e.g. periods 40 and 42, may vary depending on how different a frame of data is from the preceding frame. In Figure 10, Frame N requires a complete frame write operation, wherein all the rows of the array are strobed. To do this in both polarities requires time periods 40 and 42 as illustrated in Figures 8 and 9. For Frame N+1, only some of the rows require updates because in this example, the image data is the same for some of the rows of the array. Rows that are unchanged (e.g. row 1 and row N of Figure 10) are not strobed. Writing the new data to the array thus requires shorter periods 70 and 72 since only some of the rows need to be strobed. For Frame N+1, the hold cycles 44, 46 are extended to fill the remaining time before writing Frame N+2 is to begin. In this example, Frame N+2 is unchanged from Frame N+1. No write cycles are then needed, and the update period for Frame N+2 is completely filled with hold cycles 44 and 46. As described above, more than two hold cycles, e.g. four cycles, eight cycles, etc. could be used.

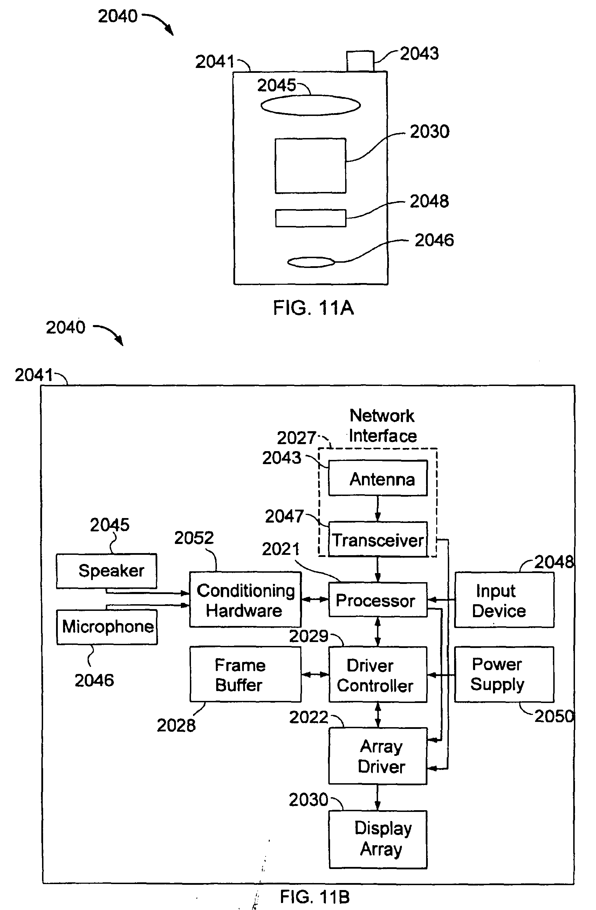

Figures 11A and 11B are system block diagrams illustrating an embodiment of a display device 2040. The display device 2040 can be, for example, a cellular or mobile telephone. However, the same components of display device 2040 or slight variations thereof are also illustrative of various types of display devices such as televisions and portable media players.

The display device 2040 includes a housing 2041, a display 2030, an antenna 2043, a speaker 2045, an input device 2048, and a microphone 2046. The housing 2041 is generally formed from any of a variety of manufacturing processes as are well known to those of skill in the art, including injection molding, and vacuum forming. In addition, the housing 2041 may be made from any of a variety of materials, including but not limited to plastic, metal, glass, rubber, and ceramic, or a combination thereof. In one embodiment the housing 2041 includes removable portions (not shown) that may be interchanged with other removable portions of different color, or containing different logos, pictures, or symbols.

The display 2030 of exemplary display device 2040 may be any of a variety of displays, including a bi-stable display, as described herein. In other embodiments, the display 2030 includes a flat-panel display, such as plasma, EL, OLED, STN LCD, or TFT LCD as described above, or a non-flat-panel display, such as a CRT or other tube device, as is well known to those of skill in the art. However, for purposes of describing the present embodiment, the display 2030 includes an interferometric modulator display, as described herein.

The components of one embodiment of exemplary display device 2040 are schematically illustrated in Figure 11B. The illustrated exemplary display device 2040 includes a housing 2041 and can include additional components at least partially enclosed therein. For example, in one embodiment, the exemplary display device 2040 includes a network interface 2027 that includes an antenna 2043 which is coupled to a transceiver 2047. The transceiver 2047 is connected to the processor 2021, which is connected to conditioning hardware 2052. The conditioning hardware 2052 may be configured to condition a signal (e.g. filter a signal). The conditioning hardware 2052 is connected to a speaker 2045 and a microphone 2046. The processor 2021 is also connected to an input device 2048 and a driver controller 2029. The driver controller 2029 is coupled to a frame buffer 2028 and to the array driver 2022, which in turn is coupled to a display array 2030. A power supply 2050 provides power to all components as required by the particular exemplary display device 2040 design.

The network interface 2027 includes the antenna 2043 and the transceiver 2047 so that the exemplary display device 2040 can communicate with one or more devices over a network. In one embodiment the network interface 2027 may also have some processing capabilities to relieve requirements of the processor 2021. The antenna 2043 is any antenna known to those of skill in the art for transmitting and receiving signals. In one embodiment, the antenna transmits and receives RF signals according to the IEEE 802.11 standard, including IEEE 802.11(a), (b), or (g). In another embodiment, the antenna transmits and receives RF signals according to the BLUETOOTH standard. In the case of a cellular telephone, the antenna is designed to receive CDMA, GSM, AMPS or other known signals that are used to communicate within a wireless cell phone network. The transceiver 2047 pre-processes the signals received from the antenna 2043 so that they may be received by and further manipulated by the processor 2021. The transceiver 2047 also processes signals received from the processor 2021 so that they may be transmitted from the exemplary display device 2040 via the antenna 2043.

In an alternative embodiment, the transceiver 2047 can be replaced by a receiver. In yet another alternative embodiment, network interface 2027 can be replaced by an image source, which can store or generate image data to be sent to the processor 2021. For example, the image source can be a digital video disc (DVD) or a hard-disc drive that contains image data, or a software module that generates image data.

Processor 2021 generally controls the overall operation of the exemplary display device 2040. The processor 2021 receives data, such as compressed image data from the network interface 2027 or an image source, and processes the data into raw image data or into a format that is readily processed into raw image data. The processor 2021 then sends the processed data to the driver controller 2029 or to frame buffer 2028 for storage. Raw data typically refers to the information that identifies the image characteristics at each location within an image. For example, such image characteristics can include color, saturation, and gray-scale level.

In one embodiment, the processor 2021 includes a microcontroller, CPU, or logic unit to control operation of the exemplary display device 2040. Conditioning hardware 2052 generally includes amplifiers and filters for transmitting signals to the speaker 2045, and for receiving signals from the microphone 2046. Conditioning hardware 2052 may be discrete components within the exemplary display device 2040, or may be incorporated within the processor 2021 or other components.

The driver controller 2029 takes the raw image data generated by the processor 2021 either directly from the processor 2021 or from the frame buffer 2028 and reformats the raw image data appropriately for high speed transmission to the array driver 2022. Specifically, the driver controller 2029 reformats the raw image data into a data flow having a raster-like format, such that it has a time order suitable for scanning across the display array 2030. Then the driver controller 2029 sends the formatted information to the array driver 2022. Although a driver controller 2029, such as a LCD controller, is often associated with the system processor 2021 as a stand-alone Integrated Circuit (IC), such controllers may be implemented in many ways. They may be embedded in the processor 2021 as hardware, embedded in the processor 2021 as software, or fully integrated in hardware with the array driver 2022.

Typically, the array driver 2022 receives the formatted information from the driver controller 2029 and reformats the video data into a parallel set of waveforms that are applied many times per second to the hundreds and sometimes thousands of leads coming from the display's x-y matrix of pixels.

In one embodiment, the driver controller 2029, array driver 2022, and display array 2030 are appropriate for any of the types of displays described herein. For example, in one embodiment, driver controller 2029 is a conventional display controller or a bi-stable display controller (e.g., an interferometric modulator controller). In another embodiment, array driver 2022 is a conventional driver or a bi-stable display driver (e.g., an interferometric modulator display). In one embodiment, a driver controller 2029 is integrated with the array driver 2022. Such an embodiment is common in highly integrated systems such as cellular phones, watches, and other small area displays. In yet another embodiment, display array 2030 is a typical display array or a bi-stable display array (e.g., a display including an array of interferometric modulators).

The input device 2048 allows a user to control the operation of the exemplary display device 2040. In one embodiment, input device 2048 includes a keypad, such as a QWERTY keyboard or a telephone keypad, a button, a switch, a touch-sensitive screen, a pressure- or heat-sensitive membrane. In one embodiment, the microphone 2046 is an input device for the exemplary display device 2040. When the microphone 2046 is used to input data to the device, voice commands may be provided by a user for controlling operations of the exemplary display device 2040.

Power supply 2050 can include a variety of energy storage devices as are well known in the art. For example, in one embodiment, power supply 2050 is a rechargeable battery, such as a nickel-cadmium battery or a lithium ion battery. In another embodiment, power supply 2050 is a renewable energy source, a capacitor, or a solar cell, including a plastic solar cell, and solar-cell paint. In another embodiment, power supply 2050 is configured to receive power from a wall outlet.

In some implementations control programmability resides, as described above, in a driver controller which can be located in several places in the electronic display system. In some cases control programmability resides in the array driver 2022. Those of skill in the art will recognize that the above-described optimization may be implemented in any number of hardware and/or software components and in various configurations.

It will be understood by those of skill in the art that numerous and various modifications can be made without departing from the spirit of the present invention. Therefore, it should be clearly understood that the forms of the present invention are illustrative only and are not intended to limit the scope of the present invention.

## Claims

1. A method of maintaining a frame of display data on an array of microelectromechanical systems (MEMS) display elements, said method comprising alternately applying approximately equal bias voltages of opposite polarities to said MEMS display elements for periods of time defined at least in part by the inverse of a rate at which frames of display data are received by a display system.

2. The method of Claim 1, wherein each said period of time is substantially equal to 1/(2f), wherein f is a defined frequency of frame refresh cycles.

3. The method of Claim 1, wherein each said period of time is substantially equal to 1/(4f), wherein f is a defined frequency of frame refresh cycles.

4. The method of Claim 1, further comprising a method of actuating the MEMS display elements, said method of actuating comprising:
writing display data to said MEMS display element with a potential difference of a first polarity during a first portion of a display write process;
re-writing said display data to said MEMS display element with a potential difference having a polarity opposite said first polarity during a second portion of said display write process.
applying a first bias potential having said first polarity to said MEMS display element during a third portion of said display write process; and
applying a second bias potential having said opposite polarity to said MEMS display element during a fourth portion of said display write process.

5. The method of Claim 4, wherein said first portion of said display write process comprises writing a first frame of display data to said array of MEMS display elements, and wherein said second portion of said display write process comprises re-writing said first frame of display data to said array of MEMS display elements.

6. The method of Claim 5, wherein said third and fourth portions of said display write process comprises holding said first frame of display data following said rewriting.

7. The method of Claim 6, additionally comprising writing a second frame of display data using said writing, re-writing, applying a first bias potential and applying a second bias potential.

8. The method of Claim 4, wherein said first portion of said display write process comprises writing a first row of display data to said array of MEMS display elements, and wherein said second portion of said display write process comprises re-writing said first row of display data to said array of MEMS display elements.

9. The method of Claim 8, wherein said third and fourth portions of said display write process comprises holding said first row of display data following said rawriting.

10. The method of Claim 9, additionally comprising writing a second row of display data using said writing, re-writing, applying a first bias potential and applying a second bias potential.

11. The method of Claim 4, wherein said first, second, third, and fourth portions of said display write process each comprise approximately one-fourth of a time period defined by the inverse of a rate at which frames of display data are received by a display system.

12. The method of Claim 4, wherein said first portion and said second portion together comprise less than 1/2 of a time period defined by the inverse of a rate at which frames of display data are received by a display system.

13. The method of Claim 4, wherein said first portion extends for a first time period and said second portion extends for a second time period.

14. The method of Claim 13, wherein said first and second time periods are different.

15. The method of Claim 14, wherein said first and second time periods are determined based at least in part on a polarity dependent dielectric charging rate.

16. The method of Claim 1, further comprising a method of writing frames of display data to the MEMS display elements at a rate of one frame per defined frame update period, said method of writing frames comprising:
writing display data to said MEMS display elements, wherein said writing takes less than said frame update period; and
applying a series of bias potentials of alternating polarity to said MEMS display elements for the remainder of said frame update period.

17. The method of Claim 16 wherein said series comprises an application of a first polarity during approximately half of said remainder of said frame update period, and an application of a second opposite polarity during approximately half of said frame update period.

18. A method of driving a microelectromechanical systems (MEMS) display comprising periodically releasing substantially all pixels of said display, wherein said periodic releasing occurs for each pixel at an infrequent rate such that there is no perceptible affect on visual appearance of the display to a normal observer.

19. The method of Claim 18, wherein said infrequent rate is a rate slower than once per hour of display use.

20. The method of Claim 18, wherein said infrequent rate is a rate slower than once per 100,000 displayed frames of image data.

21. A microelectromechanical systems (MEMS) display device comprising:
means for displaying an image having a plurality of pixels; and
means for periodically releasing substantially all pixels of said displaying means, wherein said periodic releasing occurs for each pixel at an infrequent rate such that there is no perceptible affect on visual appearance of the displaying means to a normal observer.

22. The MEMS display device of Claim 21, wherein said displaying means comprises an array of MEMS elements arranged in a plurality of rows and columns.

23. The MEMS display device of Claim 22, wherein said array comprises interferometric modulators.

24. The MEMS display device of Claim 22 or 23, wherein said releasing means comprise a driver circuit.

25. The MEMS display device of Claim 24, wherein said infrequent rate is a rate slower than once per hour of display use.

26. The MEMS display device of Claim 24, wherein said infrequent rate is a rate slower than once per 100,000 displayed frames of image data.

27. A microelectromechanical systems (MEMS) display device configured to display images at a frame update rate, said frame update rate defining a frame update period, said display device comprising:
means for displaying an image; and
means for applying a polarity balanced sequence of bias voltages to said displaying means for portions of at least one frame update period, wherein said portions are defined by a time remaining between completing a frame write process for a first frame, and beginning a frame write process for a next subsequent frame.

28. The MEMS display device of Claim 27, wherein said displaying means comprises an array of MEMS elements arranged in a plurality of rows and columns.

29. The MEMS display device of Claim 28, wherein said array comprises interferometric modulators.

30. The MEMS display device of Claim 28 or 29, wherein said applying means comprise a driver circuit.

31. The MEMS display device of Claim 30, wherein said driver circuit is configured to apply the same voltage to substantially all columns of said array during a portion of said frame update period.

32. The MEMS display device of Claim 24 or 30, further comprising:
a processor that is in electrical communication with said array, said processor being configured to process image data; and
a memory device in electrical communication with said processor.

33. The MEMS display device of Claim 30, further comprising:
a controller configured to send at least a portion of said image data to said driver circuit.

34. The MEMS display device of Claim 30, further comprising:
an image source module configured to send said image data to said processor.

35. The MEMS display device of Claim 32, wherein said image source module comprises at least one of a receiver, transceiver, and transmitter.

36. The MEMS display device of Claim 30, further comprising:
an input device configured to receive input data and to communicate said input data to said processor.
